(19) Europäisches Patentamt
European Patent Office
Office européen des brevets

(11) EP 2 657 960 A1

(12) EUROPEAN PATENT APPLICATION
published in accordance with Art. 153(4) EPC

(43) Date of publication:
**30.10.2013 Bulletin 2013/44**

(21) Application number: **11850611.2**

(22) Date of filing: **19.12.2011**

(51) Int Cl.:
***H01L 21/336*** (2006.01) ***H01L 21/28*** (2006.01)
***H01L 29/417*** (2006.01) ***H01L 29/786*** (2006.01)
***H01L 51/05*** (2006.01) ***H01L 51/30*** (2006.01)
***H01L 51/40*** (2006.01)

(86) International application number:
**PCT/JP2011/079419**

(87) International publication number:
**WO 2012/086609 (28.06.2012 Gazette 2012/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.12.2010 JP 2010286261**

(71) Applicant: **Mitsubishi Chemical Corporation**
**Chiyoda-ku**
**Tokyo 100-8251 (JP)**

(72) Inventor: **OSEKI Yosuke**
**Yokohama-shi, Kanagawa 227-8502 (JP)**

(74) Representative: **Vossius & Partner**
**Siebertstrasse 4**
**81675 München (DE)**

# (54) FIELD-EFFECT TRANSISTOR, PROCESS FOR PRODUCING THE SAME, AND ELECTRONIC DEVICE INCLUDING THE SAME

(57) The present invention is to provide a field-effect transistor having high mobility. The invention relates to a bottom-contact type field-effect transistor which comprises: a substrate; a source electrode 3 and a drain electrode 4 that have been formed over the substrate and are constituted of an inexpensive metal; and an organic semiconductor layer 6 having an annulene structure, wherein an oxide film does not exist on a surface of at least one of the source electrode 3 and the drain electrode 4, which is in contact with the organic semiconductor layer 6. The field-effect transistor is produced by a process for producing a bottom-contact type field-effect transistor that comprises forming a source electrode 3 and a drain electrode 4 that each are constituted of a metal, over a substrate; and forming an organic semiconductor layer 6 having an annulene structure, wherein after the formation of the source electrode 3 and the drain electrode 4, an oxide film removal treatment is conducted in which an oxide film 5 is removed from the surface of at least one of the electrodes 3 and 4.

[Fig. 1]

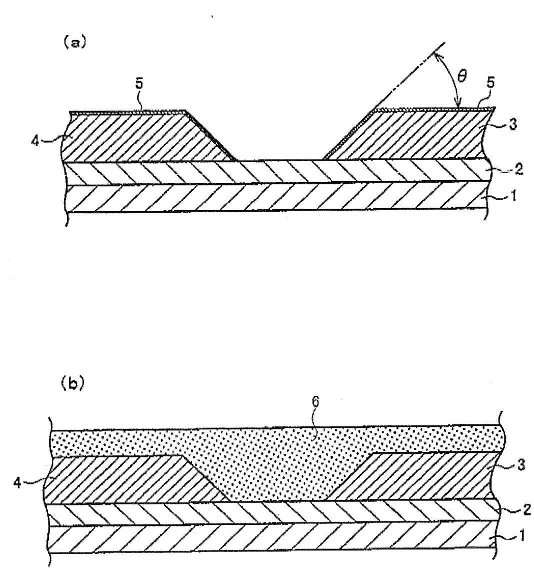


EP 2 657 960 A1

## Description

### Technical Field

The present invention relates to a field-effect transistor, in particular, a field-effect transistor having an organic semiconductor layer of an annulene structure. The invention further relates to a process for producing the field-effect transistor and to an electronic device which includes the field-effect transistor.

### Background Art

Hitherto, electronic devices such as field- effect transistors have been produced through element production processes conducted under high vacuum, such as vapor deposition, PVD (physical vapor deposition), and CVD (chemical vapor deposition) . However, the element production processes under high vacuum not only require expensive production equipment but also consume a large amount of energy in the production steps.

In contrast, a coating fluid application process for forming a semiconductor layer through coating fluid application has advantages that even an electronic device having a large area can be produced with relatively simple equipment and that the amount of the energy consumed in the production steps is small.

Incidentally, it has been reported that the contact resistance which occurs at an electrode/ semiconductor interface within a field- effect transistor is affected by the ionization potential (work function) of the electrode surface. Because of this, gold and platinum, which have a high ionization potential (work function), are usually used as the source electrodes and drain electrodes of field- effect transistors. However, gold and platinum have problems including expensiveness.

With respect to the materials of source and drain electrodes, examples have been reported in which materials other than gold and platinum are used. Usually, the source and drain electrodes of a field-effect transistor are produced in an environment where the electrodes are susceptible to oxidation. In this connection, it is known that when a metal other than gold and platinum is used, an oxide film is formed and this oxide film heightens the mobility of the field-effect transistor. Specifically, it has been reported that in the case where polyphenylenevinylene is used as a semiconductor, an improvement in mobility and a reduction in mobility unevenness are attained by using a molybdenum electrode having an $MoO_x$ layer formed on the surface thereof, as each of the source electrode and the drain electrode (see patent document 1). Furthermore, it has been reported that in the case where pentacene is used as a semiconductor, an improvement in mobility is attained by using a nickel electrode having an $NiO_x$ layer formed on the surface thereof, as each of the source electrode and the drain electrode (see patent document 2).

Meanwhile, annulene- based semiconductors, such as porphyrins and phthalocyanines, are known as organic semiconductors for field- effect transistors. Such field- effect transistors employing an annulene- based semiconductor are inexpensive and, despite this, are also required to have high mobility. Furthermore, there also is a need for a production process by which such a field- effect transistor can be easily produced.

### Prior-Art Documents

### Patent Documents

Patent Document 1: JP- A- 2005- 327797
Patent Document 2: JP- A- 2008- 10676

### Summary of the Invention

### Problems that the Invention is to Solve

Objects of the invention, which has been achieved in view of the problems described above, are to provide a field-effect transistor which employs an annulene-based semiconductor and which is inexpensive but has high mobility and to provide a process for easily producing the field-effect transistor and an electronic device which employs the field-effect transistor.

### Means for Solving the Problems

The present inventors made various investigations in order to accomplish the objects. As a result, the inventors

have found out a field-effect transistor having high mobility. The invention has been thus completed.
Essential points of the invention are as shown below.

(1) A bottom-contact type field-effect transistor which comprises a substrate; a source electrode and a drain electrode that have been formed over the substrate; and an organic semiconductor layer having an annulene structure, wherein the source electrode and the drain electrode are constituted of a metal which comprises a metal having a standard electrode potential of 1.10 V or less, or an alloy of the metal, and
an oxide film does not exist on a surface of at least one of the source electrode and the drain electrode, which is in contact with the organic semiconductor layer.
(2) A bottom-contact type field-effect transistor which comprises a substrate; a source electrode and a drain electrode that have been formed over the substrate; and an organic semiconductor layer having an annulene structure, wherein the source electrode and the drain electrode are constituted of a metal which comprises a metal other than Au and Pt, or an alloy of the metal, and
an oxide film does not exist on a surface of at least one of the source electrode and the drain electrode, which is in contact with the organic semiconductor layer.
(3) The field-effect transistor according to the item (1) or (2), wherein the non-existence of oxide film means that a difference between an ionization potential of the electrode surface and an ionization potential in case where the metal constituting the electrode(s) is a pure metal, is less than 0.7 eV, and a difference between an ionization potential of the electrode surface and an ionization potential in case where the alloy constituting the electrode(s) is a pure alloy, is below 0.7 eV.
(4) The field-effect transistor according to any one of the items (1) to (3), wherein the metal which constitutes the source electrode and the drain electrode is either a metal that does not belong to the platinum group or an alloy of the metal.
(5) The field-effect transistor according to the item (4), wherein the metal which does not belong to the platinum group is one or more kinds selected from the group consisting of Mg, Ti, V, Cr, Mn, Fe, Co, Ni, Cu, Zn, Ga, Ge, Se, Nb, Mo, Ag, In, Sn, Sb, Ta, and W.
(6) The field-effect transistor according to any one of the items (1) to (5), wherein each of edge surfaces of the source electrode and drain electrode, which face each other, are an inclined surface that forms an angle of less than 90° with a plane of the substrate.
(7) The field-effect transistor according to any one of the items (1) to (6), wherein the minimum distance between the source electrode and the drain electrode is 0.1-20 $\mu$m.
(8) A process for producing a bottom-contact type field-effect transistor, which comprises: forming a source electrode and a drain electrode that each are constituted of a metal or an alloy, over a substrate; and forming an organic semiconductor layer having an annulene structure, wherein
after the formation of the source electrode and the drain electrode, an oxide film removal treatment is conducted in which an oxide film is removed from a surface of at least one of the electrodes, and the organic semiconductor layer is formed after the treatment.
(9) The process for producing a field-effect transistor according to the item (8), wherein the oxide film removal treatment is a treatment of bringing the electrode that has an oxide film on the surface thereof into contact with a liquid in which the oxide film is soluble, thereby dissolving and removing the oxide film.
(10) The process for producing a field-effect transistor according to the item (9), wherein the oxide film is soluble in water and the liquid is water.
(11) The process for producing a field-effect transistor according to the item (9), wherein the liquid is acidic.
(12) The process for producing a field-effect transistor according to the item (9), wherein the liquid is alkaline.
(13) The process for producing a field-effect transistor according to any one of the items (8) to (12), wherein when the source electrode and the drain electrode are formed, so that each of edge surfaces of the source electrode and drain electrode, which face each other, incline at an angle of less than 90° in terms of the angle between each edge surface and a plane of the substrate.
(14) A field-effect transistor produced by the production process according to any one of the items (8) to (13).
(15) An electronic device which comprises the field-effect transistor according to any one of the items (1) to (7) and (14).

Effects of the Invention

In the field-effect transistor provided by the invention, the metal which constitutes an electrode (source electrode or drain electrode) is either an inexpensive metal or an alloy of an inexpensive metal. Despite this, the field-effect transistor has high mobility because there is no oxide film on that surface of the electrode which is in contact with the

organic semiconductor layer having an annulene structure. Furthermore, since there is no oxide film on the surface of the source electrode and drain electrode, the field-effect transistor can be expected to further produce the effect of reducing the OFF-state current or threshold voltage.

Brief Description of the Drawing

[Fig. 1] Fig. 1(a) and Fig. 1(b) are sectional views which illustrate a process for producing a field-effect transistor according to one embodiment of the invention. Modes for Carrying Out the Invention

The invention will be explained below in more detail.
Here, "% by weight" and "ppm by weight" have the same meanings as "% by mass" and "ppm by mass", respectively. The mere expression "ppm" means "ppm by weight".
The field-effect transistor of the invention is a bottom-contact type field-effect transistor which at least includes a substrate, an organic semiconductor layer having an annulene structure, a source electrode, and a drain electrode, and is characterized in that there is no oxide film on the surface of at least one of the metals which constitute the source electrode and drain electrode.
A bottom-contact type field-effect transistor according to an embodiment of the invention, which has such feature, and a process for producing the field-effect transistor are roughly explained below by reference to the drawing. Fig. 1(a) and Fig. 1(b) show a bottom-contact/bottom gate type field-effect transistor and one example of processes for producing the field-effect transistor. As shown in Fig. 1(a), a gate insulator 2 is formed on a gate electrode 1, and a source electrode 3 and a drain electrode 4 are formed on the gate insulator 2. Subsequently, the oxide films 5 which have been formed by the oxidation of the surface of the source electrode 3 and drain electrode 4 are removed. Thereafter, an organic semiconductor layer 6 having an annulene structure is formed as shown in Fig. 1(b).
Incidentally, the gate electrode 1 may be formed on a substrate. Alternatively, an electroconductive n- type silicon wafer or the like may be used so as to function as both a substrate and a gate electrode. The bottom- contact type field- effect transistor of the invention may have any configuration so long as the organic semiconductor layer has been formed on the source electrode and/or drain electrode, and the field- effect transistor may be, for example, of the top/ bottom- contact type in which only one of the source and drain electrodes has been formed on the organic semiconductor layer. Furthermore, the gate electrode may be either the bottom gate type or the top gate type. The field-effect transistor may be a dual gate type field- effect transistor which has gate electrodes respectively over and under the source electrode and drain electrode.

[Substrate]

As the substrate, use can be made of a substrate such as an inorganic material, e.g., glass or quartz, an insulating plastic, e.g., a polyimide film, polyester film, polyethylene film, poly (phenylene sulfide) film, or poly (p- xylene) film, or a hybrid material constituted of a combination of an inorganic material, a metal/ alloy sheet, and an insulating plastic. As stated above, a substrate constituted of an electroconductive n- type silicon wafer or the like may be used as a gate electrode.

[Gate Electrode]

Examples of the gate electrode include electroconductive n-type silicon wafers, films of metals such as Au, Ta, Al, Cu, Cr, Mo, W, Ti, Ag, and Pd, films of alloys of these metals, and a film composed of superposed layers of these metals or alloys. However, the gate electrode should not be construed as being limited to these examples. The gate electrode may be an electroconductive polymer such as PEDOT:PSS or may be a paste which contains nanoparticles of a metal, e.g., Ag or Au.
In the case where the gate electrode is a thin film, the thickness thereof is preferably 1 nm or larger, more preferably 50 nm or larger, and is preferably 1,000 nm or less, more preferably 500 nm or less.

[Gate Insulator]

Examples of the gate insulator include films formed by applying and burning insulating polymers such as polyimides, polyvinylphenol, poly(vinyl alcohol), polysissesquioxane, polysilazane, perhydropolysilazane, and epoxies. As the gate insulator, use may also be made of a film of $SiO_2$ or $SiN_x$, a film of aluminum oxide or tantalum oxide, or the like formed by CVD or sputtering. In the case where tantalum, aluminum, or the like is used as the gate electrode, use

may be made of a method in which the gate electrode is subjected to a treatment such as a UV treatment, ozone treatment, or anodization treatment to thereby form a film of tantalum oxide, aluminum oxide, or the like on the surface of the gate electrode and this film is used as a gate insulator. Use may also be made of a method in which the surface of the gate insulator is treated with a silane coupling agent, e.g., HMDS, and the film formed by the surface treatment is used as a gate insulator. Alternatively, a thermal oxide film formed by heating a silicon substrate in an oxygen atmosphere may be used as a gate insulator.

[Source Electrode and Drain Electrode]

As the metal for constituting the source electrode and drain electrode, use is made of either a metal having a standard electrode potential of 1.10 V or less or an alloy of the metal. Namely, the metal which constitutes the source electrode and drain electrode may be either a single metal or an alloy of two or more metals. The term "alloy of metal" means an alloy which contains, as the main component, a specific metal specified in the invention. The term "main component" herein means that the proportion by weight of this metal in all metals constituting the electrode is the highest. Although it is preferred that the metal which constitutes the source electrode and the metal which constitutes the drain electrode should be the same material, from the standpoint of case of production, the metal which constitutes the source electrode and the metal which constitutes the drain electrode may be different materials.
The standard electrode potential of the metal or alloy which constitutes the source electrode and drain electrode according to the invention is preferably -5.00 V or higher, more preferably -3.00 V or higher. The metals which have a standard electrode potential of 1.10 V or less include neither Au nor Pt. Namely, the field-effect transistor of the invention can be obtained as a field-effect transistor having high mobility, despite the nonuse of Au or Pt, which is expensive, in the source electrode and drain electrode.
The standard electrode potential is the potential of the electrode which, in electrochemical reactions (electrode reactions), is in an equilibrium state in the normal state, and is expressed in terms of potential relative to the potential of a standard hydrogen electrode as a reference (0 V). Standard electrode potential can be measured by cyclic voltammetry. The standard electrode potentials of representative metals (pure metals) are as follows: Ca (-2.84 V), Mg (-2.356 V), Be (-1.97 V), Al (-1.676 V), Ti (-1.63 V), Zr (-1.55 V), Mn (-1.18 V), Zn (-0.763 V), Cr (-0.74 V), Fe (-0.44 V), Co (-0.277 V), Ni (-0.257 V), Mo (-0.2 V), Sn (-0.138 V), Pb (-0.126 V), Cu (+0.337 V), Ag (+0.799 V), Pd (+0.915 V), Pt (+1.188 V), Au (+1.52 V).
It is preferred that the metal for constituting the source electrode and drain electrode should be any of metals other than the platinum-group metals (Ru, Rh, Pd, Os, Ir, and Pt), from the standpoints of availability, inexpensiveness, etc. Preferred of these, for use as the metal for constituting the source electrode and drain electrode, are Mg, Ti, V, Cr, Mg, Mn, Fe, Co, Ni, Cu, Zn, Ga, Ge, Se, Nb, Mo, Ag, In, Sn, Sb, Ta, W, and the like, because the oxides of these metals have electrical conductivity. Molybdenum or an alloy containing molybdenum as the main component is the most preferred as the material of the source electrode and drain electrode according to the invention.
In the case where the semiconductor layer is of the p-type, it is preferred that the ionization potential of the metal or alloy which constitutes the source electrode and drain electrode should be high. However, in the case where the semiconductor layer is of the n-type, it is preferred that the ionization potential thereof should be low. Specifically, in the case of a p-type semiconductor, the ionization potential of the metal or alloy, as measured with the ionization potential measuring device which will be shown later, is preferably 4.5 eV or higher, more preferably 4.6 eV or higher. On the other hand, in the case of an n-type semiconductor, the ionization potential of the metal or alloy is preferably 5.3 eV or less, more preferably 5.0 eV or less. The ionization potentials of metals (pure metals) as measured by the method are as follows: Mg (3.66 eV), Ti (4.33 eV), V (4.3 eV), Cr (4.5 eV), Mn (4.1 eV), Fe (4.5 eV), Co (5.0 eV), Ni (5.15 eV), Cu (4.65 eV), Zn (4.33 eV), Ga (4.2 eV), Ge (5.0 eV), Se (5.9 eV), Nb (4.3 eV), Mo (4.6 eV), Ag (4.26 eV), In (4.12 eV), Sn (4.42 eV), Sb (4.55 eV), Ta (4.25 eV), W (4.55 eV), Au (5.1 eV), Pt (5.65 eV).
It is preferred that the electrodes should be a metal or alloy which forms a water-soluble oxide film on the surface thereof, because the oxide film formed on the electrode surface can be easily removed by contact with water. Specifically, the solubility of the oxide film in water at 25°C is preferably 1 $\mu g/dm^3$ or higher, more preferably 1 $mg/dm^3$ or higher. Examples of the metal which is preferred because the oxide film thereof can be removed by contact with water include Mg, V, Zn, Ge, Se, Mo, and Ag. The solubilities of oxides of these metals in water at 25°C are as follows: MgO, 0.086 $g/dm^3$; $V_2O_5$, 10 $g/dm^3$; ZnO, 1.6 $g/dm^3$; $Ge_2O_3$, 5.2 $g/dm^3$ $SeO_2$, 384 $g/dm^3$; $MoO_3$, 1.066$g/dm^3$; $Ag_2O$, 0.025 $g/dm^3$.
The total weight (proportion) of those preferred metals in the source electrode and drain electrode according to the invention is generally 50% by weight or more, preferably 70% by weight or more, more preferably 80% by weight or more, especially preferably 90% by weight or more, most preferably 100% by weight.
It is preferred that the thickness of the source electrode and drain electrode should be large, from the standpoint that thick electrodes are less apt to suffer breakage and have low wiring resistance. However, from the standpoints of production rate and cost, it is preferred that the thickness of the electrodes should be small. Specifically, the thickness

of the source electrode and drain electrode is preferably 1 nm or larger, more preferably 50 nm or larger, and is preferably 1,000 nm or less, more preferably 500 nm or less. The composition and thickness of the source electrode may be the same as or different from the composition and thickness of the drain electrode. It is, however, preferred that the two electrodes should be equal in composition and thickness, from the standpoint of ease of formation.

In the field-effect transistor of the invention, it is preferred that those edge surfaces of the source electrode and drain electrode which face each other each should be an inclined surface that forms an angle 0 of less than 90° with the plane of the substrate.

By forming the electrode edge surfaces so as to be such inclined surfaces, the field-effect transistor having a semiconductor layer formed through coating fluid application can be made to have improved mobility. In addition, by forming the electrode edge surfaces so as to be such inclined surfaces, the field-effeot transistor having a semiconductor layer formed through coating fluid application can be reduced in mobility unevenness. The reasons for these effects are presumed to be as follows. By forming the edge surfaces as inclined surfaces, the semiconductor layer, when formed through coating fluid application, is bonded to each electrode without leaving a space between the semiconductor layer and the electrode. In addition, when the semiconductor layer contracts upon crystallization or heating after the Formation thereof, the formation of a space between each electrode and the semiconductor layer can be inhibited. Furthermore, the following is presumed. In the case where source electrode and drain electrode have been formed so that those edge surfaces thereof are inclined surfaces, an electric field concentrates at the tip of each electrode and charge injection from the source electrode into the semiconductor layer is promoted. As a result, the increase in injection resistance attributable to the decrease in ionization potential (work function) due to the removal of the surface oxide film can be diminished (compensated for).

In the invention, the angle $\theta$ is defined as the angle formed, in a cross-section which is parallel to the channel length direction and is perpendicular to the substrate, by the straight line that connects the tip of each electrode and the point which is in the side surface of the electrode that faces the channel region and which is located at a height of 10 nm from the bottom and by the plane of the gate insulator. Specifically, the angle $\theta$ can be determined by taking a photograph of a cross-section of each electrode with an SEM, thereby setting the tip of each electrode and that point in the side surface of each electrode which is located at a height of 10 nm from the bottom, and measuring that angle. The magnification of the SEM photograph is not particularly limited so long as the angle $\theta$ can be measured. However, the magnification thereof is preferably 50,000 diameters or higher.

It is preferred that the angle $\theta$ should be small, for the reasons described above. Specifically, the angle $\theta$ is more preferably 70° or less, especially preferably 45° or less, most preferably 30° or less. Meanwhile, however, the angle $\theta$ is preferably 0.1° or larger, more preferably 0.5° or larger, especially preferably 1° or larger.

The term "channel region" means the region sandwiched between the source electrode and the drain electrode which face each other. The term "channel length" means the minimum distance between the source electrode and the drain electrode. The term "channel length direction" means the direction which connects the source electrode and the drain electrode.

In the invention, it is preferred that the channel length (minimum distance between the source electrode and the drain electrode) should be small, from the standpoint of the quantity of current relative to applied voltage. Meanwhile, it is preferred that the channel length should be large, from the standpoints of diminishing property unevenness and lowering threshold voltage and OFF-state current Specifically, the channel length is preferably 0.1 $\mu$m or larger, more preferably 1 $\mu$m or larger, and is preferably 20 $\mu$m or less, more preferably 10 $\mu$m or less.

[Step for forming Source Electrode and Drain Electrode]

The source electrode and drain electrode in which the edge surfaces thereof that face each other are inclined as described above can be formed, for example, by the following methods (a) to (f). (a) A lift-off method in which use is made of a two-layer resist obtained by forming a layer of a photoresist on a lower resist which is not photosensitive, exposing the resist layers to light, and developing the exposed resist layers while controlling the developing time, thereby forming a shape in which the upper photoresist layer protrudes like a penthouse, (b) A lift-off method in which a photoresist that by itself can form an overhang shape is used. (c) A wet etching method in which an isotropic etching liquid is used. (d) A dry etching method in which an isotropic etching gas is used. (e) A dry etching method in which an end of a photoresist is tapered or a resist loss is utilized. (f) A printing method, e.g., ink-jet printing, in which ink viscosity, the surface energy of the gate insulator, etc. are controlled.

In the case of methods (a) and (b) described above, the angle $\theta$ can be controlled by changing the shape of the lift-off resist and changing the method and conditions for depositing the electrode material, etc. In the case of methods (c) to (e) described above, the angle $\theta$ can be controlled by changing the composition of the etching gas and etching liquid, etc. In the case of method (f) described above, the angle $\theta$ can be controlled by regulating the surface tension and viscosity of the electroconductive ink, the surface energy of the insulator, etc. in the printing process.
Incidentally, since methods (a) to (f) usually include steps conducted in the air, an oxide film is usually formed on the

electrode surface when the source electrode and the drain electrode are a metal which is susceptible to oxidation. Especially in the case of a method which includes baking conducted in the air or includes a resist removal step in which a UV/$O_3$ treatment or an $O_2$ plasma treatment is used, the electrode surface is apt to come into a completely oxidized state.

[Treatment for removing Oxide Film from Surface of the Source Electrode and Drain Electrode]

In a process for producing the field-effect transistor of the invention, after a source electrode and a drain electrode are formed, an oxide film removal treatment for removing the oxide film from the surfaces of at least one of the electrodes is performed and an organic semiconductor layer is formed thereafter. The oxide film removal treatment is given preferably to the source electrode, especially preferably to both the source electrode and the drain electrode, from the standpoint that the excellent effects of the invention are apt to be produced.

Metals and alloys increase in ionization potential upon oxidation. In the invention, the absence of an oxide film on the surface of the source electrode and drain electrode can be ascertained from a small difference between the ionization potential of the surface of the source electrode and drain electrode and either the ionization potential in case where the metal constituting the electrodes is a pure metal, or the ionization potential in case where the alloy constituting the electrodes is a pure alloy. In the invention, a metal in an unoxidized state is regarded as a pure metal, and an alloy in an unoxidized state is regarded as a pure alloy. Specifically, the difference between those ionization potentials is preferably less than 0.7 eV, more preferably 0.5 eV or less, especially preferably 0.3 eV or less.

With respect to the ionization potential of the surface of an electrode ($IP_s$), the ionization potential in case where the metal or alloy constituting the electrode is a pure metal or pure alloy ($IP_m$), and the ionization potential in case where the metal or pure alloy constituting the electrode has been completely oxidized ($IP_{ox}$), the value of ($IP_s$- $IP_m$) / ($IP_{ox}$- $IP_m$) is preferably less than 1.0, more preferably 0.7 or less, especially preferably 0.4 or less.

Ionization potential can be measured by photoelectron emission spectroscopy. The values of ionization potential in the invention were measured with an ionization potential measuring device (PCR-101, manufactured by OPTEL).

The field-effect transistor of the invention has high mobility because there is no oxide film on the surface of the source electrode and drain electrode as described above. Furthermore, since there is no oxide film on the surface of the source electrode and drain electrode, the field-effect transistor of the invention is expected to be reduced in OFF-state current and threshold voltage.

The higher the ionization potential of the source electrode and the lower the ionization potential of the organic semiconductor layer, the more the movement of holes from the source electrode to the organic semiconductor layer is apt to occur. In addition, metals usually increase in ionization potential upon oxidation as stated above. It has hence been thought that oxidation of the source electrode results in an increase in the mobility of the field-effect transistor. Despite this, the absence of an oxide film on the surface of the source electrode and drain electrode in the field-effect transistor of the invention is expected to bring about that effect. The reasons for this are presumed to be as follows.

In case where the oxide film 5 in Fig. 1 remains on the surface of the source electrode 3 and drain electrode 4, the source electrode 3 and the drain electrode 4 have reduced electrical conductivity and become resistive layers. In the case where the oxide film 5 is unstable to the air, for example, soluble in water, it is thought that a component of the oxide film 5 dissolves in the organic semiconductor layer 6 to produce a doping effect, which causes a decrease in mobility, an increase in OFF-state current or threshold voltage, etc. Furthermore, it is thought that in case where polar groups such as M-OH groups (M is a metal or alloy) generate on the surface of the oxide film 5, these polar groups cause charge trapping and $H_2O$ adsorption to thereby reduce the crystallinity of the semiconductor in contact with the electrode surface, resulting in a decrease in mobility, a shift of hysteresis or threshold voltage, a deterioration in S value, etc.

It is thought that especially when the edge surfaces of the source electrode 3 and drain electrode 4 are inclined surfaces, the presence of an oxide film 5 on the surface of the electrodes causes electric-field concentration, and a steep voltage gradient, etc. occur when the channel length is small. As a result, a short-channel effect is thought to be apt to arise due to an impurity attributable to the surface oxide film. This short-channel effect is presumed to be inhibited by removing the oxide film 5 present on the surface of the source electrode 3 and drain electrode 4 and forming an organic semiconductor layer 6 on the electrode surface where no oxide film is present.

This effect obtained by removing the oxide film from the surface of the source electrode and drain electrode is specifically observed in the case where an organic semiconductor layer having an annulene structure is used, as will be demonstrated by the Example to be given later. The reasons for this are presumed to be as follows.

First, it is thought that in the case where an organic semiconductor layer having an annulene structure is used, the demerits of the presence of an oxide film on the surface of the source electrode and drain electrode exceed the excellent effect brought about by the presence of the oxide film.

When there is an oxide film on the surface of the source electrode and drain electrode, there is a possibility that the semiconductor might have reduced crystallinity at the electrode- side interface and have reduced electrical conductivity, resulting in a decrease in mobility. It is thought that since the annulene structure has high symmetry and a large molecular

plane, such a phenomenon is apt to occur. In the case where a material of the coating fluid application/ conversion type which will be described later is used as a semiconductor material, substantially no solvent is present during crystallization and, hence, there is a possibility that a change in electrode surface environment due to the presence or absence of an oxide film might exert a greater influence on crystallinity as compared with the case where a semiconductor material of a coating fluid application type is used. Consequently, it is thought that the organic semiconductor layer according to the invention preferably is a material of the coating fluid application/ conversion type.

It is also thought that the electric double layer present at the interface between each electrode and the organic semiconductor layer may exert an influence. Usually, when an electrode comes into contact with a semiconductor, electrodes move from the semiconductor to the electrode to yield an electric double layer. As a result, a barrier to charge injection is formed between the semiconductor and the electrode. It is presumed that especially in the case where electrophilic oxygen has added to the surface of an electrode to form an oxide, movement of electrons from the semiconductor to the electrode is promoted and the barrier to charge injection due to the formation of an electric double layer is apt to become high. It is thought that since an organic semiconductor having an annulene structure generally has high electron-donating properties and shows intense molecular interaction, this organic semiconductor is apt to give a thicker interfacial electric double layer (a higher barrier to charge injection). It is therefore thought that when an organic semiconductor layer having an annulene structure is used, the removal of the oxide film from the surface of the source electrode and drain electrode is highly effective.

For the oxide film removal treatment, various methods including wet processes and dry processes can be utilized. A method for the oxide film removal treatment and conditions for the treatment are selected according to the material of the source electrode and drain electrode, peripheral materials such as the substrate and the gate insulator, etc. Preferred of those methods, from the standpoints of inexpensiveness and a high treatment rate, is a method (wet process) in which the electrode surface is brought into contact with a liquid in which the oxide film is soluble, thereby dissolving and removing the surface oxide film.

The dissolving liquid to be used in the wet process may be either acidic, neutral, or alkaline so long as the oxide film can be removed therewith. The acid or alkali may be either an inorganic substance or an organic substance. In the case where the oxide film formed on the electrode surface is soluble in acids, it is preferred to use an acidic dissolving liquid. In the case where the oxide film formed on the electrode surface is soluble in alkalis, it is preferred to use an alkaline dissolving liquid. Specifically, as acids, use can be made, for example, of inorganic acids such as hydrofluoric acid, hydrochloric acid, hydrobromic acid, nitric acid, sulfuric acid, phosphoric acid, boric acid, sulfurous acid, chromic acid, hypochlorous acid, hydrocyanic acid, and fluorosilicic acid and organic acids such as formic acid, acetic acid, propionic acid, butyric acid, valeric acid, caproic acid, trifluoroacetic acid, oxalic acid, citric acid, and phosphonic acids. As alkalis, use can be made of inorganic alkalis such as ammonia, sodium hydroxide, potassium hydroxide, sodium carbonate, potassium carbonate, sodium hydrogen carbonate, sodium silicate, and alkali bromates and organic alkalis such as TMAH (tetramethylammonium hydroxide), triethylamine, monoethanolamine, and pyridine.

The concentration of the acid or alkali is not particularly limited so long as the concentration thereof exerts no influence on the other members and the oxide film to be removed can be removed. Usually, however, the concentration thereof is regulated to 0.001 $mmol \cdot dm^{-3}$ to 30 $mol \cdot dm^{-3}$.

In the case where the oxide film is water-soluble, this oxide film can be removed with water. In this case, the oxide film can be dissolved away, for example, by bringing the oxide film into contact with water having ordinary or an elevated temperature. Examples of metals which form water-soluble oxides include Mg, V, Zn, Ge, Se, Mo, and Ag. The contact with water may be contact with a water-containing organic solvent.

For the purpose of preventing the dissolved oxide film from adhering again or for another purpose, an additive such as an alcohol, surfactant, or chelating agent may be added to the dissolving liquid for oxide film removal.

In the case where the oxide film is removed by a dry process, this removal may be accomplished, for example, by using an etching gas suitable for the kind of the metal or alloy oxide to be removed.

In the invention, that the oxide film has been removed is ascertained by measuring the ionization potential of the electrode surface. It is preferred that after the removal of the oxide film, an organic semiconductor layer should be formed on the electrode surface on which regeneration of a surface oxide film has proceeded as less as possible. In the case where the oxide film is removed in the air, oxidation occurs again to undesirably form an oxide film, and it is therefore preferred that an organic semiconductor layer should be formed as early as possible after the removal of the oxide film. It is also preferred that the oxide film should be removed in an inert atmosphere or under vacuum, and it is more preferred that all the operations beginning with oxide film removal and ending with formation of an organic semiconductor layer should be performed in an inert atmosphere or under vacuum.

[Organic Semiconductor Layer]

As the organic semiconductor for the field-effect transistor of the invention, use is made of an organic semiconductor having an annulene structure, such as, for example, a porphyrin or a phthalocyanine. Porphyrins are preferred

as the organic semiconductor for the field-effect transistor of the invention. Although the organic semiconductor may be of either the p-type or the n-type, the p-type is more preferred because this type is more apt to bring about the excellent effects of the invention. It is preferred that the thickness of the organic semiconductor layer should be large, from the standpoint of the stability of semiconductive properties. However, from the standpoint of attaining a low OFF-state current, it is preferred that the thickness thereof should be small. Specifically, the thickness of the organic semiconductor layer is preferably 1 nm or larger, more preferably 10 nm or larger, and is preferably 500 nm or less, more preferably 200 nm or less.

For forming the organic semiconductor layer, various methods including vacuum processes and coating fluid application processes can be employed. However, it is preferred that the semiconductor layer should be formed by a coating fluid application method. The formation of the semiconductor layer by a coating fluid application method enables the field-effect transistor to be produced at a low cost as compared with formation of the semiconductor layer by vacuum processes. Furthermore, the influence of the underlying layer on the crystallization of the semiconductor is lessened and the difference in crystal growth between the area located on the insulator and the area located on the source electrode and drain electrode decreases, as compared with the case in which the semiconductor layer is formed by vacuum deposition methods. Consequently, by forming the source electrode and drain electrode in a tapered shape, the growth of crystals lying across the boundary between the source electrode and the gate insulator and of crystals lying across the boundary between the drain electrode and the gate insulator is promoted and a space is less apt to be formed between each of the electrode tips, which are important to charge injection, and the organic semiconductor layer.

Examples of the coating fluid application method include techniques such as spin coasting, ink-jet printing, nozzle printing, dip coating, aerosol-jet printing, microcontact printing, a dip-pen method, screen printing, letterpress printing, intaglio printing, and gravure offset printing. Specifically, the following methods (g) and (h) are preferred. (g) A method in which a coating fluid containing a semiconductor is applied and the coating layer is dried to obtain a semiconductor layer. (h) A method in which a coating fluid containing a precursor for a semiconductor is applied and the precursor is thereafter converted to the semiconductor to obtain a semiconductor layer. In method (g), crystallization occurs simultaneously with the drying for solvent removal and, hence, crystal growth is apt to be affected by the conditions for the drying for solvent removal, etc. On the other hand, method (h) has an advantage that since crystallization is caused after a film of the precursor is formed first, it is easy to keep the crystallization conditions constant and to obtain an even crystal film.

The precursor for a semiconductor to be used in (h) is a compound which, through conversion, comes to have semiconductive properties. Examples of the precursor include annulene compounds having a bicyclic structure which are of the heat- or photo-conversion type and undergo the reverse Diels-Alder reaction upon heating or light irradiation. Preferred are annulene compounds having a bicyclic structure which are of the heat-conversion type and undergo the reverse Diels-Alder reaction upon heating. Preferred of these are bicyclic porphyrin compounds.

<Bicyclic Porphyrin Compounds>

Especially preferred bicyclic porphyrin compounds have a structure represented by the following formula (I) or (II).

[Chem. 1]

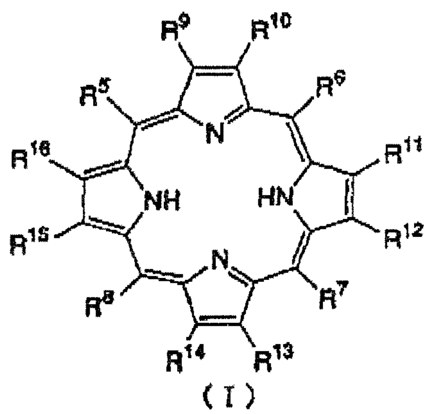

(I)

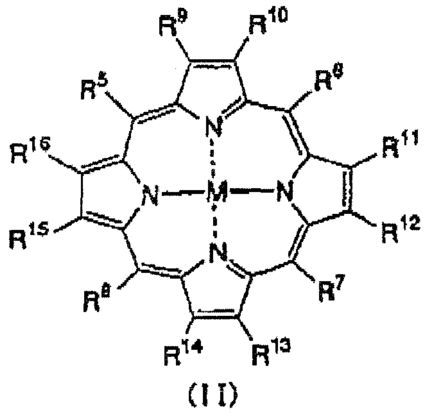

(II)

(In formulae (I) and (II), $R^5$ to $R^{16}$ each represent a hydrogen atom, a monovalent atom, or a monovalent group of atoms, and at least one pair selected from ($R^9$, $R^{10}$), ($R^{11}$, $R^{12}$), ($R^{13}$, $R^{14}$), and ($R^{15}$, $R^{16}$) has been united together to form a group represented by the following formula (III) . M represents a metal atom.
[Chem. 2]

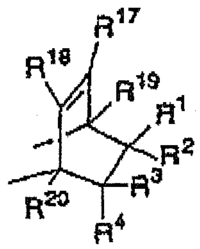

(III)

In formula (III), $R^1$ to $R^4$ each represent a hydrogen atom or an alkyl group having up to 10 carbon atoms, and at least one pair selected from ($R^1$, $R^2$) and ($R^3$, $R^4$) is a pair of alkyl groups each having up to 10 carbon atoms. $R^{17}$ to $R^{20}$ each represent a hydrogen atom, a monovalent atom, or a monovalent group of atoms.)
In formulae (I) and (II), $R^5$ to $R^8$ each represent a monovalent atom or a monovalent group of atoms. The monovalent atoms of $R^5$ to $R^8$ and the monovalent groups of atoms of $R^5$ to $R^8$ are not limited. However, it is preferred that $R^5$ to $R^8$ each should be a group which shows small steric hindrance, because such atoms or groups of atoms render the porphyrin ring less apt to be distorted and to have reduced planeness and because such atoms or groups of atoms themselves are less apt to be causative of inhibition of the overlapping of $\pi$-conjugated systems. Examples of atoms or groups of atoms which are suitable as $R^5$ to $R^8$ include a hydrogen atom, halogen atoms, and monovalent organic groups. Specific preferred examples of $R^5$ to $R^8$ include: a hydrogen atom; halogen atoms such as fluorine, chlorine, and bromine atoms; and monovalent organic groups, e.g., alkyl groups such as methyl, ethyl, propyl, and butyl and alkenyl groups such as vinyl, propanyl, and hexenyl. Especially preferred of these are hydrogen, fluorine, and chlorine atoms. In those alkyl and alkenyl groups, the carbon atoms other than those bonded to the porphyrin ring may have been substituted with substituents such as halogen atoms, e.g., fluorine or chlorine atoms, or alkyl groups.
In formulae (I) and (II), $R^9$ to $R^{16}$ each represent a monovalent atom or a monovalent group of atoms. Examples of this monovalent group of atoms include monovalent organic groups. At least one pair, preferably two or more pairs, more preferably the four pairs, of ($R^9$, $R^{10}$), ($R^{11}$, $R^{12}$), ($R^{13}$, $R^{14}$), and ($R^{15}$, $R^{16}$) each have been united together to form a group represented by formula (III) (a bicyclic group having a bicyclic structure and represented by formula (III)).
In formula (III), $R^1$ to $R^4$ each represent a hydrogen atom or an alkyl group. In the case where $R^1$ to $R^4$ each are an alkyl group, it is preferred that the number of carbon atoms of the $R^1$ to $R^4$ should be small, because the ethylene derivatives to be eliminated have a low molecular weight and a high vapor pressure and, hence, the eliminated ethylene derivatives are easy to remove from the system. Consequently, the number of carbon atoms of each alkyl group is generally 10 or less, preferably 6 or less, more preferably 3 or less.
In the case where $R^1$ to $R^4$ are alkyl groups, the alkyl groups may be linear or may have a branch. Examples of the alkyl groups in the case where $R^1$ to $R^4$ are alkyl groups include methyl, ethyl, propyl, n-butyl, and isobutyl. One of these alkyl groups may be used alone, or any desired two or more of these may be used in combination in any desired proportion.
Furthermore, in the case where $R^1$ to $R^4$ are alkyl groups, the alkyl groups may have formed one or more rings and may have substituents. Although the substituents of $R^1$ to $R^4$ are not limited, examples thereof include halogen atoms such as fluorine and chlorine atoms. One of these substituents may be used alone, or any desired two or more thereof may be used in combination in any desired proportion.
However, at least one pair selected from ($R^1$, $R^2$) and ($R^3$, $R^4$) is a pair of alkyl groups each having up to 10 carbon atoms. These alkyl groups having up to 10 carbon atoms may be linear or may have a branch. These alkyl groups may have substituents and may have formed a ring. By thus configuring the bicyclic structure so that one carbon atom in the bicyclic structure has two alkyl substituents having up to 10 carbon atoms, the bicyclic porphyrin compound can be made to have enhanced solubility in a variety of organic solvents.
In formula (III), $R^{17}$ to $R^{20}$ each represent a monovalent atom or a monovalent group of atoms. The monovalent atoms of $R^{17}$ to $R^{20}$ or the monovalent groups of atoms of $R^{17}$ to $R^{20}$ are not limited. However, it is preferred that $R^{17}$

to $R^{20}$ each should be an atom or group which shows small steric hindrance and has a small substituent, because such atoms or groups are less apt to inhibit the intermolecular overlapping of $\pi$-conjugated systems which is for enabling the organic semiconductor produced from the bicyclic porphyrin compound to show the properties thereof.

In the case where $R^{17}$ to $R^{20}$ each are a monovalent atom, examples thereof include a hydrogen atom and halogen atoms such as fluorine, chlorine, and bromine atoms.

In the case where $R^{17}$ to $R^{20}$ each are a monovalent group of atoms, this group preferably is a monovalent organic group. Examples of the monovalent organic group include: optionally substituted, linear or branched alkyl groups having 1-18 carbon atoms, such as methyl, ethyl, propyl, isopropyl, n-butyl, sec-butyl, and n-heptyl; optionally substituted cycloalkyl groups having 3-18 carbon atoms, such as cyclopropyl, cyclopentyl, cyclohexyl, and adamantly; optionally substituted, linear or branched alkenyl groups having 2-18 carbon atoms, such as vinyl, propenyl, and hexenyl; optionally substituted cycloalkenyl groups having 3-18 carbon atoms, such as cyclopentenyl and cyclohexenyl; optionally substituted, linear or branched alkynyl groups having 2-18 carbon atoms, such as propynyl and hexynyl; optionally substituted heterocyclic groups such as 2-thienyl, 2-pyridyl, 4-piperidyl, and morpholino; optionally substituted aryl groups having 6-18 carbon atoms, such as phenyl, tolyl, xylyl, and mesityl; optionally substituted aralkyl groups having 7-20 carbon atoms, such as benzyl and phenethyl; optionally substituted, linear or branched alkoxy groups having 1-18 carbon atoms such as methoxy, ethoxy, n-propoxy, isopropoxy, n-butoxy, sec-butoxy, and tert-butoxy; optionally substituted, linear or branched alkenyloxy groups having 3-18 carbon atoms, such as propenyloxy, butenyloxy, and pentenyloxy; and optionally substituted, linear or branched alkylthio groups having 1-18 carbon atoms, such as methylthio, ethylthio, n-propylthio, n-butylthio, sec-butylthio, and tert-butylthio.

Examples of the monovalent group of atoms further include nitro, nitroso, cyano, isocyano, cyanato, isocyanato, thiocyanato, isothiocyanato, mercapto, hydroxy, hydroxyamino, formyl, sulfo, carboxyl, acyl groups represented by- $COR^{24}$, amino groups represented by- $NR^{25}R^{26}$, acylamino groups represented by- $NHCOR^{27}$, carbamate groups represented by- $NHCOOR^{28}$, carboxylic acid ester groups represented by- $COOR^{29}$, acyloxy groups represented by- $OCOR^{30}$, carbamoyl groups represented by- $CONR^{31}R^{32}$, sulfonyl groups represented by- $SO_2R^{33}$, sulfamoyl groups represented by- $SO_2NR^{34}R^{35}$, sulfonic acid ester groups represented by- $SO_3R^{36}$, sulfonamide groups represented by- $NHSO_2R^{37}$, and sulfinyl groups represented by- $SOR^{38}$. In the formulate shown above, $R^{24}$, $R^{27}$, $R^{28}$, $R^{29}$, $R^{30}$, $R^{33}$, $R^{36}$, $R^{37}$, and $R^{38}$ each represent an optionally substituted hydrocarbon group or an optionally substituted heterocyclic group, and $R^{25}$, $R^{26}$, $R^{31}$, $R^{32}$, $R^{34}$ , and $R^{35}$ each represent any of a hydrogen atom, an optionally substituted hydrocarbon group, and an optionally substituted heterocyclic group.

Examples of the hydrocarbon groups represented by $R^{24}$ to $R^{38}$ include linear or branched alkyl groups, cycloalkyl groups, linear or branched alkenyl groups, cycloalkenyl groups, aralkyl groups, and aryl groups. Preferred examples among these include linear or branched alkyl groups having 1-18 carbon atoms, such as methyl, ethyl, propyl, isopropyl, n-butyl, sec-butyl, tert-butyl, and n-heptyl, cycloalkyl groups having 3-18 carbon atoms, such as cyclopropyl, cyclopentyl, cyclohexyl, and adamantly, linear or branched alkenyl groups having 2-18 carbon atoms, such as vinyl, propenyl, and hexenyl, cycloalkenyl groups having 3-18 carbon atoms, such as cyclopentenyl and cyclohexenyl, aralkyl groups having 7-20 carbon atoms, such as benzyl and phenethyl, and aryl groups having 6-18 carbon atoms, such as phenyl, tolyl, xylyl, and mesityl.

The heterocyclic groups represented by $R^{24}$ to $R^{38}$ may be either saturated heterocycles such as 4-piperidyl, morpholino, 2-morpholinyl, and piperazyl or aromatic heterocycles such as 2-furyl, 2-pyridyl, 2-thiazolyl, and 2-quinolyl. These groups each may contain a plurality of heteroatoms, and may have substituents at any bonding sites. Heterocycles of preferred structures are 5- or 6-membered saturated heterocycles, 5- or 6-membered monocycles, and aromatic heterocycles each composed of two 5- or 6-membered monocycles fused together.

It is preferred that $R^{17}$ to $R^{20}$ should be substituents which release, during the production of an organic semiconductor (heat treatment for crystallization), ethylene derivatives (ethylene compounds) that are generally gases or liquids, preferably gases, generally at ordinary pressure and 200°C, preferably at ordinary temperature and ordinary pressure.

$R^{17}$ to $R^{20}$ may have been substituted with any desired substituents. Examples of the substituents include: alkoxy groups having 1- 10 carbon atoms, such as methoxy, ethoxy, n- propoxy, isopropoxy, n- butoxy, sec- butoxy, and tert- butoxy; alkoxyalkoxy groups having 2- 12 carbon atoms, such as methoxymethoxy, ethoxyethoxy, propoxymethoxy, ethoxyethoxy, propoxyethoxy, and methoxybutoxy; alkoxyalkoxyalkoxy groups having 3- 15 carbon atoms, such as methoxymethoxymethoxy, methoxymethoxyethoxy, methoxyethoxymethoxy, ethoxymethoxymethoxy, and ethoxyethoxymethoxy; aryl groups having 6- 12 carbon atoms, such as phenyl, tolyl, and xylyl (these groups may have been substituted with any desired substituents) ; aryloxy groups having 6- 12 carbon atoms, such as phenoxy, tolyloxy, xylyloxy, and naphthyloxy; and alkenyloxy groups having 2- 12 carbon atoms, such as allyloxy and vinyloxy.

Furthermore, other substituents include: heterocyclic groups such as 2- thienyl, 2- pyridyl, 4- piperidyl, and morpholino; cyano; nitro; hydroxyl; amino; alkylamino groups having 1- 10 carbon atoms, such as N, N- dimethylamino and N, N- diethylamino; alkylsulfonylamino groups having 1- 6 carbon atoms, such as methylsulfonylamino, ethylsulfonylamino, and n- propylsulfanylamino; halogen atoms such as fluorine, chlorine, and bromine atoms; carboxyl; alkoxycarbonyl groups having 2- 7 carbon atoms, such as methoxycarbonyl, ethoxycarbonyl, n- propoxycarbonyl, isopropoxycarbonyl, and n- butoxycarbonyl; alkylcarbonyloxy groups having 2- 7 carbon atoms, such as methylcarbonyloxy, ethylcarbonyloxy, n- propylcabonyloxy, isopropylcarbonyloxy, and n- butylcarbonyloxy; and alkoxycarbonyloxy groups having 2- 7 carbon atoms, such as methoxycarbonyloxy, ethoxycarbanyloxy, n- propoxycarbonyloxy, isopropoxycarbonyloxy, and n- butoxycarbonyloxy. One of these substituents may be used alone, or any desired two or more thereof may be used in combination in any desired proportion.

From the standpoint of making the bicyclic porphyrin compound to be reduced in steric hindrance and have small substituents, it is preferred that $R^{17}$ to $R^{20}$ each should be, for example, any of a hydrogen atom, a halogen atom, and a monovalent organic group, among the examples of $R^{17}$ to $R^{20}$ shown above. Specific examples of such preferred atoms or groups include a hydrogen atom; halogen atoms such as fluorine, chlorine, and bromine atoms; and monovalent organic groups, e.g., alkyl groups such as methyl, ethyl, propyl, and butyl and alkenyl groups such as vinyl, propanyl, and hexenyl. Especially preferred of these are hydrogen, fluorine, and chlorine atoms.

Of $R^9$ to $R^{16}$, those which do not form a bicyclic group represented by formula (III) are not limited so long as these each are a monovalent atom or a monovalent group of atoms. However, it is preferred that the atoms or groups represented by $R^9$ to $R^{16}$ which do not form a bicyclic group of formula (III) should be atoms or groups which show small steric hindrance and have a small substituent like $R^{17}$ to $R^{20}$, because such atoms or groups are less apt to inhibit the intermolecular overlapping of $\pi$-conjugated systems which is for enabling the organic semiconductor produced from the bicyclic porphyrin compound according to the invention to show the properties thereof.

Examples of the $R^9$ to $R^{16}$ which do not form a bicyclic group represented by formula (III) include the same atoms and groups enumerated above as examples of $R^{17}$ to $R^{20}$. The groups represented by the $R^9$ to $R^{16}$ which do not form a bicyclic group represented by formula (III) may have been substituted with any desired substituents unless the substituents considerably lessen the effects of the invention. Examples of the substituents include the same groups as those shown above as examples of the substituents of $R^{17}$ to $R^{20}$.

In formula (II), M represents a metal atom. Examples of the M include a single metal atom such as Cu, Zn, Mg, Ni, Co, or Fe and a group of atoms which is a divalent group constituted of a metal having a valence of 3 or higher and one or more other elements bonded thereto, such as AlCl, TiO, FeCl, or $SiCl_2$. Preferred of these, as M, is any one member selected from the group consisting of Cu, Zn, and Ni. In particular, Cu and Zn bring about satisfactory semiconductive properties. Meanwhile, Ni is especially preferred because this bicyclic porphyrin compound has especially low solubility when the bicyclic group has no alkyl substituent and comes to have especially improved solubility upon substitution of the bicyclic group with an alkyl group.

Especially suitable examples of the bicyclic porphyrin compound are shown by the following formulae (IV) to (VI). The following compounds are examples in which $R^1$=$R^2$=Me (Me represents methyl) and $R^3$=$R^4$=H. However, $R^1$ and $R^2$ each may be a group akin to methyl. Examples of the group akin to methyl include alkyl, branched alkyl, and alkoxy groups which have a larger chain length than methyl. One of these substituents may be use alone, or any desired two or more thereof may be used in combination in any desired proportion. Because of the nature of synthesis, a compound in which ($R^1$, $R^2$) and ($R^3$, $R^4$) have been replaced by each other is also yielded, and isomers which differ in the position of a methyl substituent or a mixture of these isomers is also obtained by the synthesis.

[Chem. 3]

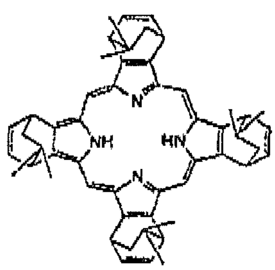

(IV)

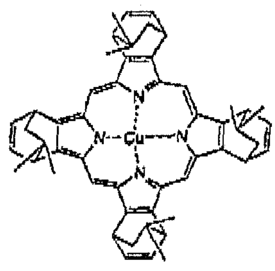

(V)

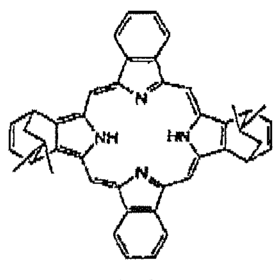

(VI)

The heat-conversion type porphyrins having a bicyclic structure undergo conversion (elimination of ethylene compounds), such as the conversion from the following formula (VII) to the following formula (VIII), when heated usually to 150°C or higher, in particular, to about 150-250°C. The porphyrins are thereby crystallized to give an organic semiconductor film having an annulene structure and high mobility.

[Chem. 4]

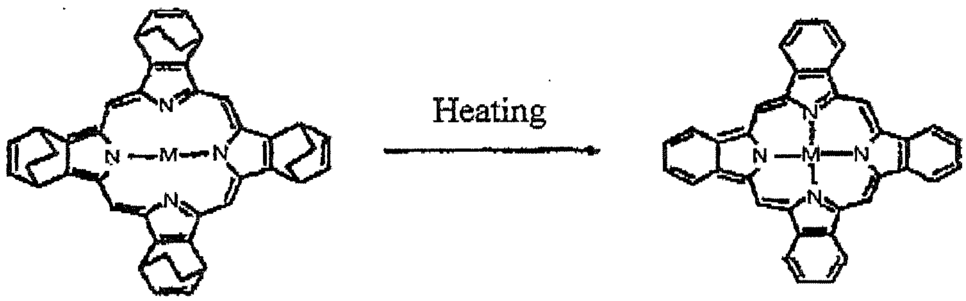


(VII) (VIII)

M in the formulae represents a metal atom, and preferably is the same metal as the M described above. Bicyclic porphyrin compounds form exceedingly large crystals to give a semiconductor film having high mobility. Because of this, in the case of a field-effect transistor which has been formed so as to have the preferred channel length described above, charge injection between each electrode and the semiconductor layer is apt to be a bottleneck to an improvement in mobility. Furthermore, bicyclic porphyrin compounds have a low ionization potential and are thought to undergo an electronic interaction with oxygen or an oxidation reaction especially when the compounds have a metallic element at the center of the porphyrin ring. Meanwhile, it is thought that when there is an oxide layer on the surface of the source electrode and drain electrode, that part of the semiconductor which is in contact with the source electrode and drain electrode undergoes a reaction or electronic interaction with oxygen and thereby comes to have reduced mobility or reduced electrical conductivity, resulting in a decrease in the mobility of the field-effect transistor. It is, however, thought that by removing the oxide layer present on the surface of the source electrode and drain electrode, the decrease in mobility can be prevented.

[Applications of the Field-Effect Transistor]

The field-effect transistor of the invention can be utilized in electronic devices, photoelectric devices, and the like. The field-effect transistor of the invention can be advantageously used in electronic devices. Examples of the electronic devices include display elements, electronic tags, electromagnetic-wave and pressure sensors, and the like.

Examples

The invention is explained below by reference to Example and Comparative Examples. In the following Example and Comparative Examples, ionization potential was measured with an ionization potential measuring device (PCR-101, manufactured by OPTEL). The operations in the Example, including the property measurements, were conducted in a clean room having a temperature of 23°C and a humidity of 50-60%.

[EXAMPLE 1]

<First Step: Formation of gate insulator>

As shown in Fig. 1, a silicon oxide film having a thickness of 300 nm was formed as a gate insulator 2 by thermal oxidation on a surface of an electroconductive n-type silicon wafer serving both as a substrate and a gate electrode 1. The gate insulator has a capacitance (Ci) of $1.15\times10^{-4}$ F/m$^2$ on the assumption that the permittivity thereof is 3.9.

<Second Step: Formation of source electrode and drain electrode>

Next, a polymethylglutarimide (PMGI) resist (SF- 9, manufactured by Kayaku Microchem Co., Ltd.) was applied in a thickness of 0.5 $\mu$m by spin coating on the silicon oxide film formed by thermal oxidation. The coating film was heated at 180°C for 5 minutes to form a resist film. Furthermore, a negative photoresist (ZPN- 1150, manufactured by

Nippon Zeon Co., Ltd.) was applied in a thickness of 4 μm on the resist film by spin coating, and this coating film was heated at 80°C for 180 seconds. Thereafter, the resist layers were exposed to light for 40 seconds, heated at 110°C for 120 seconds, and then developed with an organic alkaline developing solution (NPD- 18, manufactured by Nagase ChemteX Corp.) to obtain a resist pattern.

Molybdenum was deposited in a thickness of 100 nm by sputtering on the two-layer resist pattern obtained. Thereafter, the unnecessary part of the molybdenum was removed together with the two-layer resist pattern by the lift-off method, thereby forming a source electrode 3 and a drain electrode 4 which each had an inclined edge surface. The inclination 0 of each edge surface (angle between the edge surface and the substrate) was measured through an examination of a cross-section at a magnification of 50,000 diameters with an SEM, and was found to be 1°. The length and width of the channel between the source electrode 3 and the drain electrode 4 were 11 μm and 500 μm, respectively.

<Third Step: Removal of oxide film from electrode surface>

The substrate which had undergone up to the second step was subjected to 5-minute ultrasonic cleaning in acetone, subsequently subjected to 5-minute ultrasonic cleaning in ultrapure water in order to remove the $MoO_x$ layer present on the surface of the molybdenum, and then subjected to 5-minute ultrasonic cleaning in IPA (isopropyl alcohol). This substrate was transferred, within 1 minute thereafter, to a gloved box filled with an $N_2$ atmosphere (oxygen concentration, less than 1 ppm; dew point, below -65°C), and was dried by heating on a hot plate at 210°C for 20 minutes.

<Fourth Step: Formation of organic semiconductor layer>

Subsequently, in the gloved box filled with an $N_2$ atmosphere, a 0.7% by weight chloroform (manufactured by Wako Pure Chemical Industries, Ltd.; infinitely pure) solution of a porphyrin derivative that had a bicyclic structure and was represented by formula (VII) in which M is Cu and that was of the heat- conversion type undergoing the reverse Diels- Alder reaction upon heating was applied by spin coating and heated at 210°C for 20 minutes. The porphyrin derivative was thereby converted and crystallized to form an organic semiconductor layer. Thus, a field- effect transistor was produced.

<Measurement of Ionization Potential>

Molybdenum was deposited in a thickness of 100 nm on a glass substrate by sputtering under the same conditions as in the second step described above, and the ionization potential of the surface thereof was measured. As a result, the ionization potential thereof was found to be 5.3 eV. From the fact that the ionization potential of pure molybdenum is 4.6 eV (see Herbert B. Michaelson, Journal of Applied Physics, Vol.48, No.11, November 1977) and the fact that the ionization potential of $MoO_3$ is 5.3 eV (see APPLIED PHYSICS LETTERS, 88, 073508 (2006)), it was indirectly ascertained that also in the second step described above, the surface of the electrodes had been oxidized by the oxygen contained in the air and an $MoO_x$ layer had been thereby formed to heighten the ionization potential.

Furthermore, in the same manner as in the third step described above, this substrate was subjected to ultrasonic cleaning, thereafter transferred, within 1 minute, to a gloved box filled with an $N_2$ atmosphere (oxygen concentration, less than 1 ppm; dew point, below- 65°C), and then dried by heating on a hot plate at 210°C for 20 minutes. This substrate was exposed to the air and disposed, within 1 minute, in the ionization potential measuring device. Pressure reduction was initiated and the ionization potential of the electrode surface was measured. As a result, the ionization potential thereof was found to be 4.6 eV. It was thus ascertained that the surface oxide film had been removed.

<Measurement of Mobility>

In the following Example and Comparative Examples, "mobility" was determined by determining the output characteristics of the produced semiconductor element in dry nitrogen using "Agilent 4155c Semiconductor Parameter Analyzer" under the conditions of a drain voltage of -30 V and gate voltages of +10 V to -30 V, determining the value of $I_d^{sat}$ using the following equation, and calculating the mobility from $\sqrt{I_d^{sat}}$ and the inclination of the straight line ofVg.

[Math. 1]

$$I_d^{sat} = (WC_i/2L)\mu^{sat}(Vg-V_{th})^2$$

In the equation, $I_d^{sat}$ is drain current, W is channel width, $C_i$ is the capacitance of the gate insulator, L is channel

length, $\mu^{sat}$ is mobility, $V_g$ is gate voltage, and $V_{th}$ is threshold voltage.
Four field-effect transistors produced in the manner described above (through the first to the fourth steps) were examined for mobility. As a result, the mobility thereof was found to be 2.2 $cm^2/V{\cdot}s$ on average.

[COMPARATIVE EXAMPLE 1]

Field- effect transistors were produced in the same manner as in Example 1, except that the ultrasonic cleaning with ultrapure water and the removal of an $MoO_x$ layer in the third step were omitted. Specifically, the substrate that had undergone up to the second step was treated in a third step in which the substrate was subjected to 5- minute ultrasonic cleaning in acetone, subsequently subjected to 5- minute ultrasonic cleaning in IPA (isopropyl alcohol), thereafter transferred, within 1 minute, to a gloved box filled with an $N_2$ atmosphere (oxygen concentration, less than 1 ppm; dew point, below- 65°C), and then dried by heating on a hot plate at 210°C for 20 minutes.

Four field-effect transistors produced in the manner described above (through the first to the fourth steps) were examined for mobility As a result, the mobility thereof was found to be 1.5 $cm^2/V{\cdot}s$ on average.
Furthermore, a molybdenum film in the same state as the electrodes which had undergone that third step was produced and examined for ionization potential. As a result, the ionization potential thereof was found to be 5.3 eV. It was thus ascertained that the oxide layer present on the surface of the molybdenum electrodes is not removed by the cleaning with IPA. The molybdenum film to be examined for ionization potential was produced by depositing molybdenum in a thickness of 100 nm on a glass substrate by sputtering under the same conditions as in the second step described above, subsequently subjecting the glass substrate to 5-minute ultrasonic cleaning in acetone and then to 5-minute ultrasonic cleaning in IPA (isopropyl alcohol), thereafter transferring the glass substrate, within 1 minute, to a gloved box filled with an $N_2$ atmosphere (oxygen concentration, less than 1 ppm; dew point, below -65°C), and then drying the substrate by heating on a hot plate at 210°C for 20 minutes.

[REFERENCE EXAMPLE 1]

Field- effect transistors were produced in the same manner as in Example 1, except that in the third step, the substrate which had undergone the cleaning with IPA was allowed to stand for 3 hours in the air atmosphere within the clean room to cause an $MoO_x$ layer to generate again on the surface of the molybdenum electrodes and this substrate was thereafter subjected to IPA cleaning again.

Four field-effect transistors produced in the manner described above were examined for mobility. As a result, the mobility thereof was found to be 1.3 $cm^2/V{\cdot}s$ on average.

Furthermore, a molybdenum film in the same state as the electrodes which had undergone that third step was produced and examined for ionization potential. As a result, the ionization potential thereof was found to be 5.3 eV. It was thus found that an oxide film had been formed on the surface of the molybdenum electrodes. The molybdenum film to be examined for ionization potential was produced by depositing molybdenum in a thickness of 100 nm on a glass substrate by sputtering under the same conditions as in the second step described above, subsequently subjecting the glass substrate to 5- minute ultrasonic cleaning in acetone, 5- minute ultrasonic cleaning in ultrapure water, and 5-minute ultrasonic cleaning in IPA (isopropyl alcohol), allowing the cleaned substrate to stand in the air atmosphere for 3 hours, subjecting this substrate again to 5- minute ultrasonic cleaning in IPA (isopropyl alcohol), thereafter transferring the substrate, within 1 minute, to a gloved box filled with an $N_2$ atmosphere (oxygen concentration, less than 1 ppm; dew point, below- 65°C), and then drying the substrate by heating on a hot plate at 210°C for 20 minutes.

[REFERENCE EXAMPLE 2]

Field- effect transistors were produced in the same manner as in Example 1, except that in the third step, the substrate which had undergone the cleaning with IPA was heated at 150°C for 5 minutes in the clean room having an air atmosphere to cause an $MoO_x$ layer to generate again on the surface of the molybdenum electrodes and this substrate was thereafter subjected to IPA cleaning again.

Four field-effect transistors produced in the manner described above were examined for mobility. As a result, the mobility thereof was found to be 1.5 $cm^2/V{\cdot}s$ on average.
Furthermore, a molybdenum film in the same state as the electrodes which had undergone that third step was produced and examined for ionization potential. As a result, the ionization potential thereof was found to be 5.3 eV. It was thus found that an oxide film had been formed on the surface of the molybdenum electrodes. The molybdenum film to be examined for ionization potential was produced by depositing molybdenum in a thickness of 100 nm on a glass substrate by sputtering under the same conditions as in the second step described above, subsequently subjecting the glass substrate to 5-minute ultrasonic cleaning in acetone, 5-minute ultrasonic cleaning in ultrapure water, and 5-minute ultrasonic cleaning in IPA (isopropyl alcohol), then heating the cleaned substrate at 150°C for 5 minutes in the air

atmosphere, subsequently subjecting this substrate again to 5-minute ultrasonic cleaning in IPA (isopropyl alcohol), thereafter transferring the substrate, within 1 minute, to a gloved box filled with an $N_2$ atmosphere (oxygen concentration, less than 1 ppm; dew point, below -65°C), and then drying the substrate by heating on a hot plate at 210°C for 20 minutes.

[Discussion]

Example 1, in which there was no oxide film on the surface of the molybdenum electrodes, had a higher mobility as compared with Comparative Example 1 and Reference Examples 1 and 2, in which there was an $MoO_x$ layer on the surface.

[REFERENCE EXAMPLE 3]

In order to elucidate oxidation of the surface of a molybdenum electrode by atmospheric oxygen, a 100-nm thin film of molybdenum was formed on a glass substrate by sputtering and the ionization potential thereof was measured. As a result, the surface of the thin molybdenum film, immediately after the film formation, had an ionization potential of 4.6 eV. Meanwhile, the surface of the thin molybdenum film which had been allowed to stand for 30 minutes in the clean room had an ionization potential of 5.0 eV; it was ascertained that oxidation of the molybdenum electrode surface by the oxygen present in the air had proceeded. Furthermore, the surface of the thin molybdenum film which had been allowed to stand for 1 hour and 30 minutes in the clean room had an ionization potential of 5.2 eV, and the surface of the thin molybdenum film which had been allowed to stand for 3 hours therein had an ionization potential of 5.3 eV; it was ascertained that oxidation of the molybdenum electrode surface by the oxygen present in the air had further proceeded in each case.

Moreover, the thin molybdenum film, immediately after the formation thereof, was heated at 150°C for 5 minutes. As a result, the ionization potential of the surface of this thin molybdenum film had increased to 5.3 eV It was ascertained that the oxidation was accelerated by heating. The surface of the thin molybdenum film was oxidized also in the case where the substrate was subjected to a 5- minute $UV/O_3$ treatment, and the ionization potential thereof increased to 5.3 eV.

These thin molybdenum films which had been oxidized were subjected to 5-minute ultrasonic cleaning in ultrapure water. As a result, the ionization potential of the surface of each thin molybdenum film decreased to 4.6 eV. It was thus ascertained that the oxide film formed on the surface of the molybdenum can be removed by washing with water.

[COMPARATIVE EXAMPLE 2]

A field-effect transistor was produced in the same manner as in Example 1, except that in the fourth step, an organic semiconductor layer was formed by vacuum-depositing pentacene (product obtained through purification by vacuum sublimation; manufactured by Tokyo Kasei Kogyo Co., Ltd.) in a thickness of 100 nm. The field-effect transistor produced was examined for mobility. As a result, the mobility thereof was found to be 0.063 $cm^2/V \cdot s$.

[COMPARATIVE 3]

A field-effect transistor was produced in the same manner as in Comparative Example 1, except that in the fourth step, an organic semiconductor layer was formed by vacuum-depositing pentacene (product obtained through purification by vacuum sublimation; manufactured by Tokyo Kasei Kogyo Co., Ltd.) in a thickness of 100 nm. The field-effect transistor produced was examined for mobility. As a result, the mobility thereof was found to be 0.10 $cm^2/V \cdot s$.

[Discussion]

In the case where the organic semiconductor layer was pentacene, Comparative Example 2, in which there was no oxide film on the molybdenum electrode surface, had a lower mobility as compared with Comparative Example 3, in which there was an $MoO_x$ layer on the surface.

[COMPARATIVE EXAMPLE 4]

A field- effect transistor was produced in the same manner as in Example 1, except that in the fourth step, an organic semiconductor layer was formed by spin- coating a 1% by weight chloroform (manufactured by Wako Pure Chemical Industries, Ltd.; infinitely pure) solution of poly (3- hexylthiophene) (manufactured by ALDRICH) and heating the coating layer at 120°C for 60 minutes. The field- effects transistor produced was examined for mobility. As a result, the mobility thereof was found to be 0.00033 $cm^2/V \cdot s$.

[COMPARATIVE EXAMPLE 5]

A field- effect transistor was produced in the same manner as in Comparative Example 1, except that in the fourth step, an organic semiconductor layer was formed by spin- coating a 1% by weight chloroform (manufactured by Wako Pure Chemical Industries, Ltd.; infinitely pure) solution of poly (3- hexylthiophene) (manufactured by ALDRICH) and heating the coating layer at 120°C for 60 minutes. The field- effect transistor produced was examined for mobility. As a result, the mobility thereof was found to be 0.00083 $cm^2/V \cdot s$.

[Discussion]

In the case where the organic semiconductor layer was poly (3- hexylthiophene), Comparative Example 4, in which there was no oxide film on the molybdenum electrode surface, had a lower mobility as compared with Comparative Example 5, in which there was an $MoO_x$ layer on the surface.

While the invention has been described in detail and with reference to specific embodiments thereof, it will be apparent to one skilled in the art that various changes and modifications can be made therein without departing from the spirit and scope thereof.
This application is based on a Japanese patent application filed on December 22, 2010 (Application No. 2010- 286261), the contents thereof being incorporated herein by reference.

Description of the Reference Numerals

1 Gate electrode
2 Gate insulator
3 Source electrode
4 Drain electrode
5 Oxide film
6 Organic semiconductor layer

**Claims**

1. A bottom-contact type field-effect transistor which comprises a substrate; a source electrode and a drain electrode that have been formed over the substrate; and an organic semiconductor layer having an annulene structure, wherein the source electrode and the drain electrode are constituted of a metal which comprises a metal having a standard electrode potential of 1.10 V or less, or an alloy of the metal, and
an oxide film does not exist on a surface of at least one of the source electrode and the drain electrode, which is in contact with the organic semiconductor layer.

2. A bottom-contact type field-effect transistor which comprises a substrate; a source electrode and a drain electrode that have been formed over the substrate; and an organic semiconductor layer having an annulene structure, wherein the source electrode and the drain electrode are constituted of a metal which comprises a metal other than Au and Pt, or an alloy of the metal, and
an oxide film does not exist on a surface of at least one of the source electrode and the drain electrode, which is in contact with the organic semiconductor layer.

3. The field-effect transistor according to claim 1 or 2, wherein the non-existence of oxide film means that a difference between an ionization potential of the electrode surface and an ionization potential in case where the metal constituting the electrode(s) is a pure metal, is less than 0.7 eV, and a difference between an ionization potential of the electrode surface and an ionization potential in case where the alloy constituting the electrode(s) is a pure alloy, is below 0.7 eV.

4. The field-effect transistor according to any one of claims 1 to 3, wherein the metal which constitutes the source electrode and the drain electrode is either a metal that does not belong to the platinum group or an alloy of the metal.

5. The field-effect transistor according to claim 4, wherein the metal which does not belong to the platinum group is one or more kinds selected from the group consisting of Mg, Ti, V, Cr, Mn, Fe, Co, Ni, Cu, Zn, Ga, Ge, Se, Nb, Mo,

Ag, In, Sn, Sb, Ta, and W.

**6.** The field-effect transistor according to any one of claims 1 to 5, wherein each of edge surfaces of the source electrode and drain electrode, which face each other, are an inclined surface that forms an angle of less than 90° with a plane of the substrate.

**7.** The field-effect transistor according to any one of claims 1 to 6, wherein the minimum distance between the source electrode and the drain electrode is 0.1-20 μm.

**8.** A process for producing a bottom-contact type field-effect transistor, which comprises: forming a source electrode and a drain electrode that each are constituted of a metal or an alloy, over a substrate; and forming an organic semiconductor layer having an annulene structure, wherein
after the formation of the source electrode and the drain electrode, an oxide film removal treatment is conducted in which an oxide film is removed from a surface of at least one of the electrodes, and the organic semiconductor layer is formed after the treatment.

**9.** The process for producing a field-effect transistor according to claim 8, wherein the oxide film removal treatment is a treatment of bringing the electrode that has an oxide film on the surface thereof into contact with a Liquid in which the oxide film is soluble, thereby dissolving and removing the oxide film.

**10.** The process for producing a field-effect transistor according to claim 9, wherein the oxide film is soluble in water and the liquid is water.

**11.** The process for producing a field-effect transistor according to claim 9, wherein the liquid is acidic.

**12.** The process for producing a field-effect transistor according to claim 9, wherein the liquid is alkaline.

**13.** The process for producing a field-effect transistor according to any one of claims 8 to 12, wherein when the source electrode and the drain electrode are formed, so that each of edge surfaces of the source electrode and drain electrode, which face each other, incline at an angle of less than 90° in terms of the angle between each edge surface and a plane of the substrate.

**14.** A field-effect transistor produced by the production process according to any one of claims 8 to 13.

**15.** An electronic device which comprises the field-effect transistor according to any one of claims 1 to 7 and 14.

[Fig. 1]

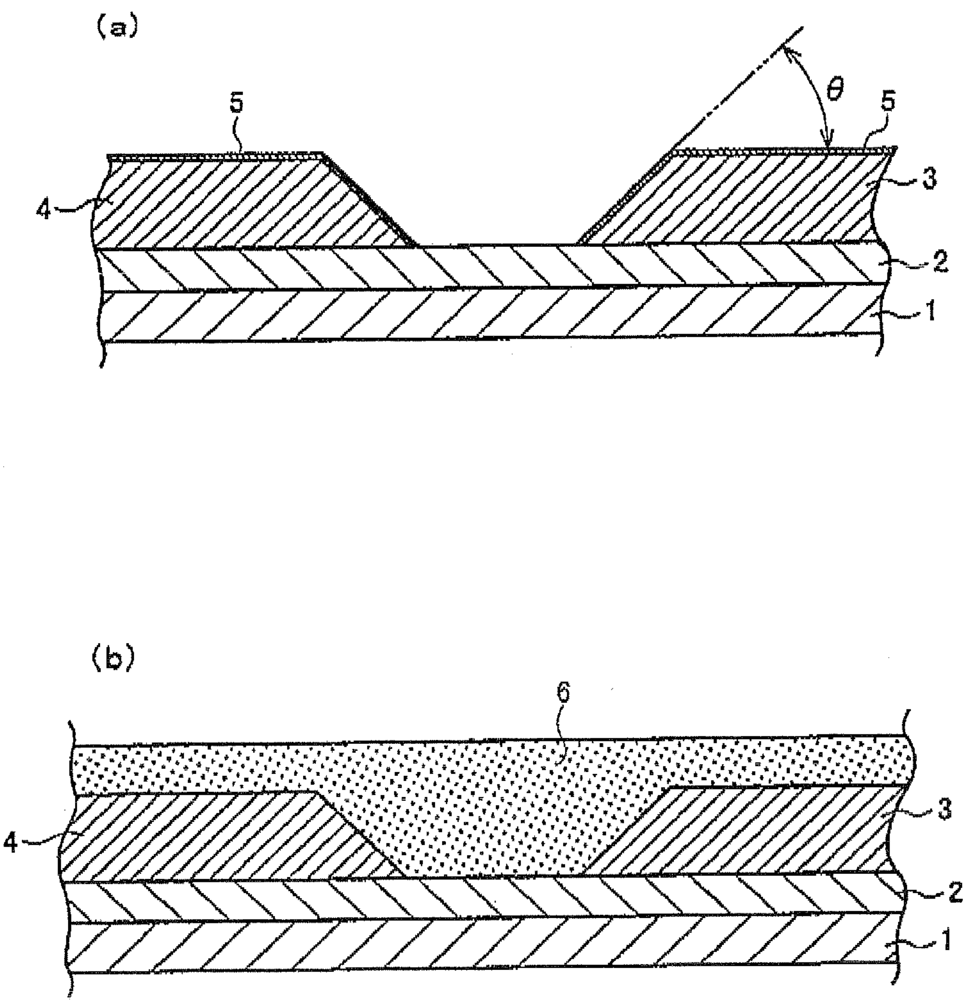

**INTERNATIONAL SEARCH REPORT**

International application No.
PCT/JP2011/079419

A. CLASSIFICATION OF SUBJECT MATTER
*H01L21/336*(2006.01)i, *H01L21/28*(2006.01)i, *H01L29/417*(2006.01)i, *H01L29/786*(2006.01)i, *H01L51/05*(2006.01)i, *H01L51/30*(2006.01)i, *H01L51/40*(2006.01)i

According to International Patent Classification (IPC) or to both national classification and IPC

B. FIELDS SEARCHED

Minimum documentation searched (classification system followed by classification symbols)
H01L21/336, H01L21/28, H01L29/417, H01L29/786, H01L51/05, H01L51/30, H01L51/40

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2010-034394 A (Idemitsu Kosan Co., Ltd.), 12 February 2010 (12.02.2010), paragraphs [0010], [0043] to [0050], [0062]; fig. 2<br>& US 2010/0283041 A1 & EP 2194582 A1<br>& WO 2009/041254 A1 & KR 10-2010-0057074 A<br>& CN 101809749 A | 1-5,7,15<br>6,8-15 |
| Y | JP 2007-524241 A (Samsung Electronics Co., Ltd.), 23 August 2007 (23.08.2007), paragraph [0033]<br>& US 2008/0283833 A1 & WO 2005/076367 A1<br>& KR 10-2005-0080276 A | 6,13 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13 March, 2012 (13.03.12) | 03 April, 2012 (03.04.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/079419

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2009-536439 A (LG Chem, Ltd.), 08 October 2009 (08.10.2009), paragraphs [0010] to [0013] & US 2009/0108254 A1 & EP 2030481 A & WO 2007/129874 A1 & KR 10-2007-0109925 A & CN 101438627 A | 8-15 |
| Y | JP 2008-060117 A (Konica Minolta Holdings, Inc.), 13 March 2008 (13.03.2008), paragraphs [0055] to [0059] (Family: none) | 8-15 |
| Y | JP 07-030119 A (Toshiba Corp.), 31 January 1995 (31.01.1995), paragraph [0005] (Family: none) | 8-15 |

Form PCT/ISA/210 (continuation of second sheet) (July 2009)

**INTERNATIONAL SEARCH REPORT**

International application No.
PCT/JP2011/079419

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The invention of claim 1 does not have a special technical feature, since the invention is disclosed in JP 2010-034394 A (Idemitsu Kosan Co., Ltd.), 12 February 2010 (12.02.2010), paragraphs 0010, 0043-0050, 0062, fig. 2, & US 2010/0283041 A1 & EP 2194582 A1 & WO 2009/041254 A1 & KR 10-2010-0057074 A & CN 101809749 A, which is found in course of this search.

As a result, there is no special technical feature common to all claims.

Consequently, this international patent application does not comply with the requirement of unity of invention.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005327797 A
- JP 2008010676 A
- JP 2010286261 A

### Non-patent literature cited in the description


- **HERBERT B. MICHAELSON.** *Journal of Applied Physics,* November 1977, vol. 48 (11
- *APPLIED PHYSICS LETTERS,* 2006, vol. 88, 073508